# EUROPÄISCHE PATENTSCHRIFT

(11) **EP 1 215 716 B1**
(45) Veröffentlichungstag und Bekanntmachung des Hinweises auf die Patenterteilung: **31.05.2006**
(21) Anmeldenummer: 01128538.4
(22) Anmeldetag: 29.11.2001
(51) Int. Cl.: H01L 21/00, H01L 21/68

(54) **Halteeinrichtung**
Supporting means
moyens de support

(30) Priorität: 13.12.2000 DE 10062011
(43) Veröffentlichungstag der Anmeldung: 19.06.2002
(73) Patentinhaber: Infineon Technologies AG, 81669 München (DE)
(72) Erfinder: Aigner, Kurt, 9073 Viktring (AT); Binder, Alfred, 9500 Landskron (AT); Kroupa, Gerhard, 9500 Villach (AT); Matschitsch, Martin, 9181 Feistritz i. Ros. (AT); Pucher, Gerhard, 9500 Villach (AT); Scherf, Werner, 8130 Frohnleiten (AT); Unterweger, Josef, 9520 Annenheim (AT); Zerlauth, Stefan, 9020 Klagenfurt (AT)
(74) Vertreter: Müller - Hoffmann & Partner

(56) Entgegenhaltungen:
- EP-A- 0 699 606
- EP-A- 1 091 389
- US-A- 5 692 873
- US-A- 6 022 417

## Beschreibung

Die Erfindung betrifft eine Halteeinrichtung, insbesondere eine Greifeinrichtung, einen Greifer oder dergleichen, gemäß dem Oberbegriff des Anspruchs 1, mit dem scheibenförmige Gegenstände, insbesondere Wafer, Dünnwafer oder dergleichen, wie sie in der Halbleitertechnik verwendet werden, gehandhabt werden können.

Für das Halten und Handhaben von Wafern sind Halteeinrichtungen oder Greifer bekannt, an welchen Wafer durch Unterdruck, mit dem Vakuumöffnungen in der Oberfläche des Greifers beaufschlagt werden, an den Greifer angesaugt werden (siehe z.B. das Dokument US-A-6022417). Bei diesen mit Unterdruck arbeitenden Greifern können die Öffnungen, über die Unterdruck wirksam wird, in Anzahl, Form und Verteilung fast beliebig variiert werden. Ein Nachteil dieser bekannten Greifer ist, dass der Unterdruck bei stark verbogenen Wafern nicht wirksam werden kann, um die Wafer zum Greifer hin zu ziehen, da wenigstens teilweise zwischen den Öffnungen, an die Unterdruck angelegt wird, und dem Wafer selbst ein zu großer Abstand vorliegt.

Es sind auch Greifer für Wafer vorgeschlagen worden, bei welchen der Wafer am Greifer durch ein aus wenigstens einer Düse ausströmendes Druck-Gas durch auf Grund des Bernoulliprinzips erzeugte Kräfte festgehalten wird. Bei solchen Greifern tritt wenigstens an einer Stelle im Greifer, in dessen dem Wafer zugekehrten Fläche ein unter Druck stehendes Gas, z.B. Luft oder Stickstoff, aus. Die so erzeugte Strömung zwischen Wafer und Greifer lässt nach dem Bernoulliprinzip eine Kraft entstehen, die den Wafer zum Greifer hin zieht. Von Vorteil bei diesen Greifern ist es an sich, dass die nach dem Bernoulliprinzip entstehende Kraft auch stark gebogene Wafer zum Greifer hin zieht, also der Wafer wenigstens weitgehend eben ausgerichtet oder planarisiert werden kann. Nachteilig bei diesen Bernoulligreifern hingegen ist, dass das Halten von Wafern nach dem Bernoulliprinzip in Räumen mit verringertem Druck, z.B. Vakuumkammern oder dergleichen, problematisch ist.

Für Chucks, auf denen Wafer gehalten werden, während sie bearbeitet oder behandelt werden, ist es auch bekannt, den Wafer am Chuck durch elektrostatische Kräfte zu fixieren. Durch die elektrostatischen Kräfte erfolgt im Wafer eine Ladungstrennung und der Wafer wird zum Chuck hin gezogen. Nachteilig bei dem Halten von Wafern an Chucks nach dem Elektrostatikprinzip ist, dass hohe elektrische Spannungen bis zu +/-3 kV nötig sind, um einen Wafer halten zu können. Allerdings sind die auftretenden Coulombschen Kräfte sehr schwach, weil die Kräfte mit dem Quadrat Abstandes zwischen Wafer und Greifer abnehmen. Manche Kräfte genügen meist nicht, um stark gebogene Wafer zu der Greiferoberfläche hin zu ziehen.

Da heutzutage Wafer immer dünner werden - bei Wafergrößen von 0.14m - 0.2m (5,6 und 8 Zoll) bis zu 50 µm - sind herkömmliche Greifer nicht mehr einsetzbar. Dünne Wafer sind nicht nur außerordentlich bruchgefährdet, sondern weisen zusätzlich oft Verbiegungen von bis zu 16 mm aus der Waferebene heraus auf, und sind überdies u.U. stark verspannt.

Um verbogene Wafer sicher handhaben zu können, z.B. beim Beund Entladen von Horden, Quarzbooten usw., ist es erforderlich, den Wafer auf einem Greifer eben zu stabilisieren.

Der Erfindung liegt die Aufgabe zu Grunde, eine Halteeinrichtung für das Handhaben von scheibenförmigen Gegenständen, insbesondere für Halbleiterwafer, Dünnwafer oder dergleichen, zu schaffen, mit dem, insbesondere dünne und gebogene Wafer, sicher und einfach gehandhabt werden können.

Gelöst wird diese Aufgabe mit einer Halteeinrichtung erfindungsgemäß durch die kennzeichnenden Merkmale des Anspruches 1. Bevorzugte und vorteilhafte Ausgestaltungen sind Gegenstand der unabhängigen Unteransprüche.

Nachfolgend werden die Begriffe Halteeinrichtung, Greifereinrichtung und Greifer synonym zueinander verwendet. Ebenso wird unter einem Wafer oder Halbleiterwafer immer auch ein Dünnwafer verstanden.

Bei der erfindungsgemäßen Halteeinrichtung wird zum Halten des Wafers sowohl das Bernoulliprinzip als auch das elektromagnetische Prinzip angewandt. Dabei werden u.U. gebogene und verspannte Wafer zunächst durch auf Grund des Bernoulliprinzips erzeugte Kräfte eben ausgerichtet oder planarisiert, zur Halteeinrichtung oder zum Greifer hin gezogen und dann auf dem Greifer durch elektromagnetische, insbesondere elektrostatische Kräfte gehalten.

Bei dem erfindungsgemäßen Greifer sind einerseits Einrichtungen für das Halten nach dem Bernoulliprinzip und andererseits Einrichtungen für das Halten durch elektromagnetische, insbesondere elektrostatische, Kräfte verwirklicht. Zum Halten eines einmal an den Greifer angelegten Wafers kann die Zufuhr des Gases, das auf Grund des Bernoulliprinzips den Wafer planarisierende Kräfte erzeugt, abgeschaltet und nur die Elektrostatik beibehalten werden. Dadurch können mit dem erfindungsgemäßen Greifer Wafer auch in Räumen mit verringertem Gas- oder Luftdruck gehalten und gehandhabt werden. Im Vakuum wirkt das Bernoulliprinzip nicht, das kann aber durch die elektromagnetischen Kräfte kompensiert werden.

In der Praxis wird beim Verwenden einer erfindungsgemäßen Halteeinrichtung für das Planarisieren und Stabilisieren des Wafers durch auf Grund des Bernoulliprinzips entstehende Kräfte zunächst durch einen Kanal unter Druck stehendes Gas, z.B. Luft oder Stickstoff, mit mehrfachen Atmosphärendruck zu wenigstens einer Düse geführt, die auf der Greiferoberfläche ausmündet. Die Düse, durch die das Druckgas austritt kann kreisförmig ausgebildet und/oder segmentweise unterbrochen sein, und einen Radius im Bereich von 20 bis 25 % des Greiferdurchmessers haben. Die Ausströmöffnung für das Druckgas, das die Haltekraft nach dem Bernoulliprinzip bewirkt, kann entweder schräg, z.B. unter spitzem Winkel, beispielsweise 20°, oder im Wesentlichen parallel zur Greiferoberfläche ausgerichtet sein. Bei dem erfindungsgemäßen Greifer können an Stellen einer kreisförmigen und/oder segmentweise unterbrochenen Düse auch mehrere Einzeldüsen, die mit unter Druck stehendem Gas beaufschlagt werden, vorgesehen sein. Solche Einzeldüsen haben bevorzugt Ausrichtungen, die zur Ebene des Greifers schräg gerichtet sind, wobei bevorzugt ist, dass die Ausrichtung der Düsen so gewählt ist, dass das unter Druck stehende Gas aus den Einzeldüsen in einer zur Achse des Greifers schräg gestellten und zum Rand des Greifers hin gerichteten Strömungsrichtung austritt.

Das elektrostatische Feld wird mit wenigstens zwei bipolar entgegengesetzt angesteuerten Elektroden verwirklicht, wobei sich über den Elektrodenflächen ein Dielektrikum befindet. Bevorzugt ist es, wenn das Flächenverhältnis zwischen der oder den positiv und der oder den negativ geladenen Elektrode bzw. Elektroden bei etwa eins liegt.

In einer bevorzugten Ausführungsform ist der Grundkörper des Greifers mit den Kanälen für die Strömung des Druckgases aus einem nichtmetallischen Werkstoff gefertigt. Der Grundkörper kann aber auch aus einem anderen als einem nichtmetallischen Werkstoff gefertigt sein.

Die Bestandteile des Greifers, die einen Wafer durch elektrostatische Kräfte am Greifer halten, können durch verschiedene Verfahren hergestellt werden und werden in den Greifer integriert, beispielsweise durch Dickschichthybridtechnologie mit speziellen Keramiken als Dielektrika oder mit Hilfe beschichteter Folien.

Die erfindungsgemäße Ausbildung des Greifers erlaubt es, dessen geometrische Abmessungen auf seine beabsichtigte Verwendung hin anzupassen.

Der erfindungsgemäße Greifer kann dünn ausgebildet sein, wobei die Dicke des Greifers durch die für das Halten nach dem Bernoulliprinzip erforderlichen Kanäle vorgegeben ist, weil die elektrostatischen Komponenten sehr flach gehalten werden können, z.B. einige 100 µm.

Bei einer Ausführungsform des erfindungsgemäßen Greifers ist die Austrittsöffnung für das Druckgas für das Bernoulliprinzip schräg zur Greiferoberfläche ausgerichtet, so dass die Elektroden für das Halten des Wafers nach dem Elektrostatikprinzip in den Greifer eingearbeitet werden können und die gesamte Greiferoberfläche eben ist.

Bei einer anderen Ausführungsform können die Elektroden zueinander konzentrisch angeordnet sein, wobei die Düse für den Austritt des Druckgases zwischen den Elektroden vorgesehen sein kann.

Es besteht auch die Möglichkeit, zwei halbkreisförmige Elektroden innerhalb der Düse für den Austritt des Druckgases anzuordnen.

Bei einer Ausführungsform, bei der Gas für das Bernoulliprinzip aus der Düse tangential zur Greiferoberfläche strömt, ergibt sich in der dem Wafer zugewandten Fläche des Greifers eine Stufe von reinigen 100 µm, die es erlaubt, die Elektroden für die Elektrostatik in der obersten Ebene einzuarbeiten. Diese Ausführungsform hat den Vorteil, dass der Wafer durch die nach dem Bernoulliprinzip entstehende Kraft an die Elektroden gedrückt wird und an diesen anliegt.

In besonderen Fällen kann eine Ausführungsform des erfindungsgemäßen Greifers verwendet werden, bei der zusätzlich zu den Einrichtungen zum Halten eines Wafers nach dem Bernoulliprinzip und dem elektrostatischen Prinzip in der dem Wafer zugewandten Fläche des Greifers wenigstens eine mit Unterdruck beaufschlagte Öffnung, z.B. in "Vakuumkopf" oder dergleichen, vorgesehen ist.

Bei einer Ausführungsform des erfindungsgemäßen Greifers, bei dem wenigstens eine mit Unterdruck beaufschlagte Öffnung vorgesehen ist, besteht die Möglichkeit, die mit Unterdruck beaufschlagten Öffnungen als Vakuumköpfe auszubilden, die senkrecht zur Ebene des Greifers beweglich sind. Diese Ausführungsform hat den Vorteil, dass die Vakuumköpfe, wenn sie nicht mit Unterdruck beaufschlagt sind, über die Greiferfläche vorstehen, so dass ein sicheres Wirksamwerden des Unterdrucks zum Festhalten eines Wafers möglich ist. Sobald die Vakuumköpfe mit Unterdruck beaufschlagt sind, bewegen sie sich in den Greifer hinein, bis ihre obere Endfläche, an der der Wafer durch Unterdruck gehalten wird - wenigstens im Wesentlichen - in der Ebene der dem Wafer zugekehrten Fläche des Greifers angeordnet ist. So ist ein sicheres und ebenes Halten des Wafers gewährleistet.

Beim Verwenden des erfindungsgemäßen Greifers können die Funktionen zum Halten eines Wafers, nämlich das Halten durch elektrostatische Kräfte, durch auf Grund des Bernoulliprinzips entstehende Kräfte und - sofern vorgesehen - durch Unterdruck einzeln oder in beliebigen Kombinationen angesteuert werden und somit zum Halten eines Wafers wirksam sein.

Die erforderlichen Zuführungen - insbesondere für Druckgas, eventuelles Vakuum und Elektrostatik - und deren Anschlüsse können in verschiedener Weise verwirklicht werden. Diese Zuführungen können zum Beispiel in einem Griff des Greifers durch Kanalsysteme für Druckgas und Vakuum und Leitungen für das elektrische Potential verwirklicht sein. Außerdem können diesbezüglich auch entsprechende Maßnahmen für den Einsatz des erfindungsgemäßen Greifers in Räumen, in denen verringerter Druck herrscht, vorgesehen werden.

Weitere Einzelheiten, Merkmale und Vorteile der Erfindung ergeben sich aus der nachstehenden Beschreibung von bevorzugten Ausführungsbeispielen erfindungsgemäßer Halteeinrichtungen an Hand der Zeichnungen.
- Fig. 1: zeigt schematisch im Schnitt eine erste Ausführungsform der erfindungsgemäßen Halteeinrichtung.
- Fig. 2: zeigt schematisch im Schnitt eine zweite Ausführungsform der erfindungsgemäßen Halteeinrichtung.
- Fig. 3: zeigt schematisch im Schnitt eine dritte Ausführungsform der erfindungsgemäßen Halteeinrichtung.
- Fig. 4: zeigt eine Ausführungsform der erfindungsgemäßen Halteeinrichtung mit kreisringförmig angeordneten Elektroden.
- Fig. 5: zeigt eine Ausführungsform der erfindungsgemäßen Halteeinrichtung mit Elektroden in der Mitte der Halteeinrichtung.
- Fig. 6: zeigt eine Ausführungsform der erfindungsgemäßen Halteeinrichtung mit segmentförmigen Elektroden und einer Mittelelektrode.
- Fig. 7: zeigt eine Ausführungsform der erfindungsgemäßen Halteeinrichtung mit einer mit Unterdruck beaufschlagbaren Öffnung.
- Fig. 8: zeigt teilweise im Schnitt eine Einzelheit der erfindungsgemäßen Halteeinrichtung mit senkrecht zur Greiferfläche beweglichem Vakuumkopf ohne Unterdruckbeaufschlagung.
- Fig. 9: zeigt die Einzelheit der Ausführungsform aus Fig. 8 bei mit Unterdruck beaufschlagtem Vakuumkopf.
- Fig. 10: zeigt eine andere Ausführungsform eines senkrecht zur Greiferfläche beweglichen Vakuumkopfes ohne Unterdruckbeaufschlagung.
- Fig. 11: zeigt den Vakuumkopf der Ausführungsform von Fig. 10 mit Beaufschlagung durch Unterdruck.

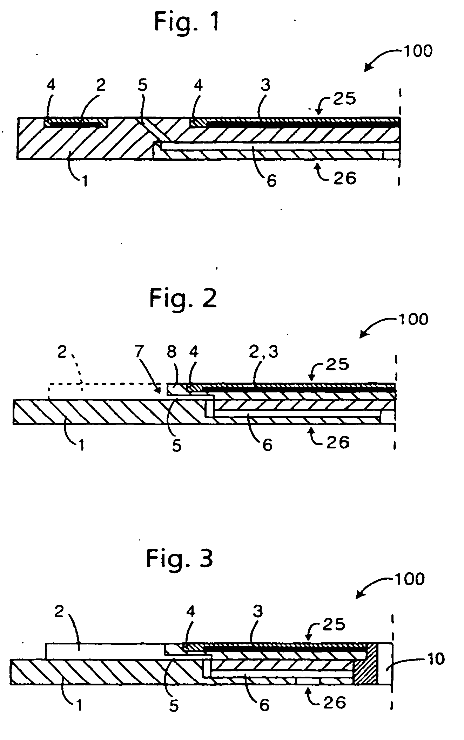

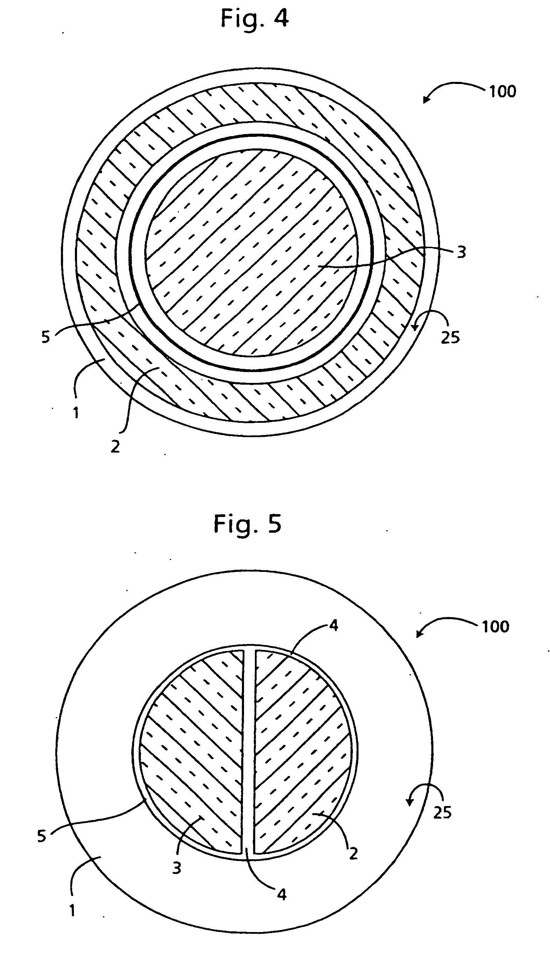

Bei der in Fig. 1 im Schnitt und in Fig. 4 in Draufsicht gezeigten Ausführungsform eines erfindungsgemäßen Greifers 100 sind in einen Grundkörper 1 in Form einer kreisförmigen Scheibe in Vertiefungen an der Oberseite 25, also der dem zu haltenden Wafer zugekehrten Seite 25 des Grundkörpers 1 eine ringförmige Elektrode 2 und eine kreisscheibenförmige Elektrode 3 angeordnet. Die Elektroden 2 und 3 sind im Dielektrikum 4 eingebettet, das auch die nach oben weisenden Flächen der Elektroden 2 und 3 bedeckt.

Im Grundkörper 1 ist eine kreisförmige Düse 5 vorgesehen, die unter einem spitzen Winkel zu der dem Wafer zugekehrten Fläche 25 des Grundkörpers 1 mündet. Die Düse 5 wird über einen im Grundkörper vorgesehenen Kanal 6 mit Druckgas, z.B. Luft oder vorzugsweise Stickstoff, beaufschlagt.

Die Elektroden 2 und 3 sind in ihrer Größe so bemessen, dass das Flächenverhältnis zwischen der Elektrode 2 und 3 in der Größenordnung von eins liegt.

Die Elektroden 2 und 3 werden bipolar entgegengesetzt angesteuert, so dass sich ein elektrostatisches Feld ausbildet, das einen auf den Greifer 100 aufgelegten Wafer (nicht gezeigt) anzieht, so dass er an der in Fig. 1 oben liegenden Fläche 25 des Greifers anliegt.

Um den Wafer in große Annäherung an den Greifer 100, nämlich der in Fig. 1 oben liegende Fläche 25 zu bewegen, wird wenigstens zu Beginn des Anlegens eines Wafers an den Greifer 100 die Düse 5 über den Kanal 6 mit Druckgas beaufschlagt, so dass durch das aus der Düse 5 ausströmende und zwischen der Grundplatte 1 und dem Wafer abströmende Gas nach dem Bernoulliprinzip Kräfte erzeugt werden, die den Wafer zum Greifer 100 hin ziehen. Diese aufgrund des Bernoulliprinzips durch das abströmende Gas erzeugten Kräfte sind hinreichend groß, um den Wafer auch dann sicher an die obere Fläche 25 des Greifers 100 zu ziehen, wenn der Wafer gebogen ist, d.h. gebogene Wafer werden gleichzeitig eben ausgerichtet oder planarisiert. Sobald der Wafer so an den Greifer 100 herangezogen worden ist, kann die Zufuhr von Druckgas zur Düse 5 unterbrochen werden, und der Wafer wird ausschließlich aufgrund der elektrostatischen Kräfte, die durch die Elektroden 2 und 3 erzeugt werden, sicher in Anlage an die ihm zugekehrte Fläche 25 des Greifers 100 gehalten.

Bei der in Fig. 2 gezeigten Ausführungsform ist die dem Wafer zugekehrte Seite 25 des Grundkörpers 1 dadurch gestuft ausgebildet, dass in der Mitte des Grundkörpers 1 eine kreisförmige Erhebung 8 vorgesehen ist. Im Bereich der so gebildeten Stufe 7 mündet die Düse 5, die über den Kanal 6 mit Druckgas beaufschlagt wird, aus. Wie Fig. 2 zeigt, ist die Ausströmrichtung von Druckgas aus der Düse 5 bei der in Fig. 2 gezeigten Ausführungsform im Wesentlichen parallel zur Flächenersrreckung des Grundkörpers 1.

In einer Vertiefung in der Erhebung 8 des Grundkörpers 1 - dieser Teil kann durch einen gesonderten Bauteil gebildet sein - sind zwei halbkreisförmig ausgebildete Elektroden 2 und 3 angeordnet. Die Elektroden 2 und 3 sind auch bei der in Fig. 2 gezeigten Ausführungsform eines erfindungsgemäßen Greifers 100 nach oben hin durch ein Dielektrikum 4 abgedeckt und durch das Dielektrikum 4 (siehe Fig. 5) voneinander isoliert.

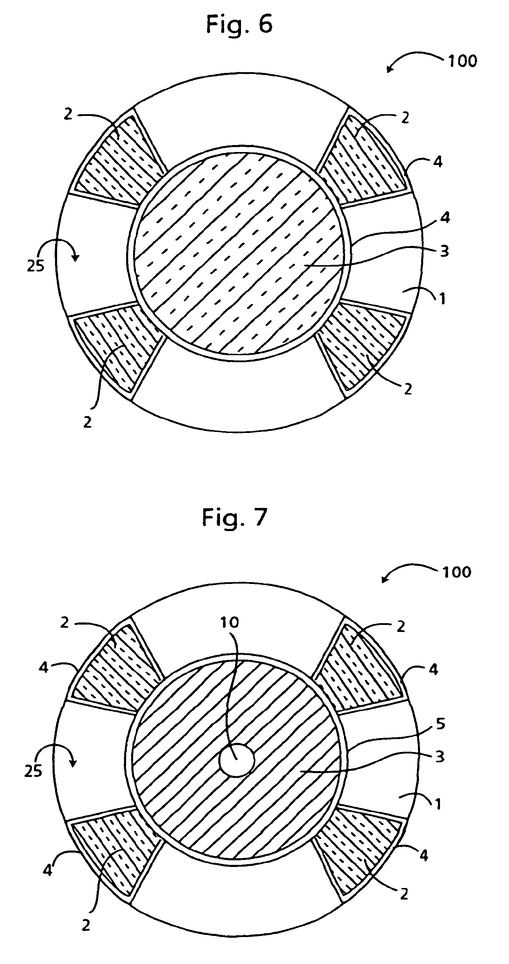

Die in Fig. 2 und 5 gezeigte Ausführungsform eines erfindungsgemäßen Greifers 100 kann so abgeändert werden, wie dies in Fig. 6 gezeigt und durch die gestrichelte Linie in Fig. 2 angedeutet ist. Bei dieser abgeänderten Ausführungsform ist in der Vertiefung in der vorspringenden Erhebung 8 des Grundkörpers 1 eine einzige Elektrode 3 vorgesehen. Außerhalb der kreisförmigen Elektrode 3 und außerhalb der Stufe 7 sind kreisringsegmentförmige Elektroden 2 angeordnet. Diese Elektroden 2 sind oben ebenfalls durch ein Dielektrikum 4 abgedeckt.

Die Fig. 3 und 7 zeigen eine gegenüber der Ausführungsform von Fig. 6 abgewandelte Ausführungsform, bei der in der Mitte des Greifers 100 eine mit Unterdruck beaufschlagbare Öffnung 10 vorgesehen ist, um eine zusätzliche Haltekraft für einen am Greifer 100 festgelegten Wafer zu erzeugen. Eine solche mit Unterdruck beaufschlagte Öffnung 10 kann auch bei allen anderen gezeigten Ausführungsformen verwirklicht sein.

Es ist darauf hinzuweisen, dass die Form und Anordnung der Elektroden 2 und 3 des erfindungsgemäßen Greifers in beliebiger Weise abgeändert werden kann. Auch ist die Ausrichtung und Art sowie die Größe der Düse 5, durch die Druckgas für das Erzeugen von dem Wafer zum Greifer 100 hinziehenden Kräften nach dem Bernoulliprinzip nicht wesentlich. So können neben kreisförmigen oder kreisbogenförmigen Düsen auch Düsen in Form von Bohrungen, die beispielsweise entlang eines Kreises im Grundkörper 1 des Greifers 100 angeordnet sind, vorgesehen sein.

Bei allen gezeigten Ausführungsformen eines erfindungsgemäßen Greifers 100 kann statt einer ringförmigen Düse 5 für das Erzeugen einer einen Wafer zum Greifer 100 hin ziehenden Kraft nach dem Bernoulliprinzip auch eine Mehrzahl von Düsen 5 vorgesehen sein. Diese Düsen 5 können kreisbogenförmige Düsen 5 sein oder Düsen 5, die als Bohrungen ausgeführt sind. Wenn die mit Druckgas für das Erzeugen einer Haltekraft nach dem Bernoulliprinzip vorgesehenen Düsen 5 als Bohrungen ausgeführt sind, sind diese bevorzugt auf einem zum Mittelpunkt des Greifers 100 konzentrischen Kreis angeordnet und bevorzugt so ausgerichtet, dass sie zur dem Wafer zugekehrten Fläche 25 des Greifers 100 schräg ausgerichtet sind. Dabei ist eine Ausrichtung der Düsen 5 bevorzugt, bei der die Achsen der Düsen 5 schräg nach außen weisen, wie dies für die ringförmige Düse 5 im Querschnitt von Fig. 1 gezeigt ist.

Wenn mehrere als Bohrungen ausgeführte Düsen 5 vorgesehen sind, können diese, wie erwähnt, längs eines Kreises angeordnet sein, der so angeordnet ist, wie dies in den Fig. 4 bis 7 für eine kreisförmige Düse 5 gezeigt ist. Bei dieser Ausführungsform sind die Bohrungen über den Umfang des Kreises, an dem die kreisringförmige Düse 5 ausmündet, verteilt vorgesehen.

Es ist auch eine Ausführungsform eines erfindungsgemäßen Greifers 100 in Betracht gezogen, bei der die mit Druckgas beaufschlagten Düsen 5 innerhalb der Elektroden 2 und/oder 3 angeordnet sind. Beispielsweise können schrägen als Düsen 5 für das Erzeugen einer Haltekraft nach dem Bernoulliprinzip ausgeführten Bohrungen auch durch die mittlere Elektrode 3 geführt sein, in welchem Fall in diesen Kanälen eine Isolierung in Form eines Dielektrikums 4 vorgesehen ist.

Wenn der erfindungsgemäße Greifer 100 mit einer Einrichtung zum Halten eines Wafers mit Hilfe von Unterdruck ausgeführt ist, kann Unterdruck so wie dies an Hand der Fig. 3 und 7 beschrieben ist, durch eine mittige Öffnung 10 angelegt werden.

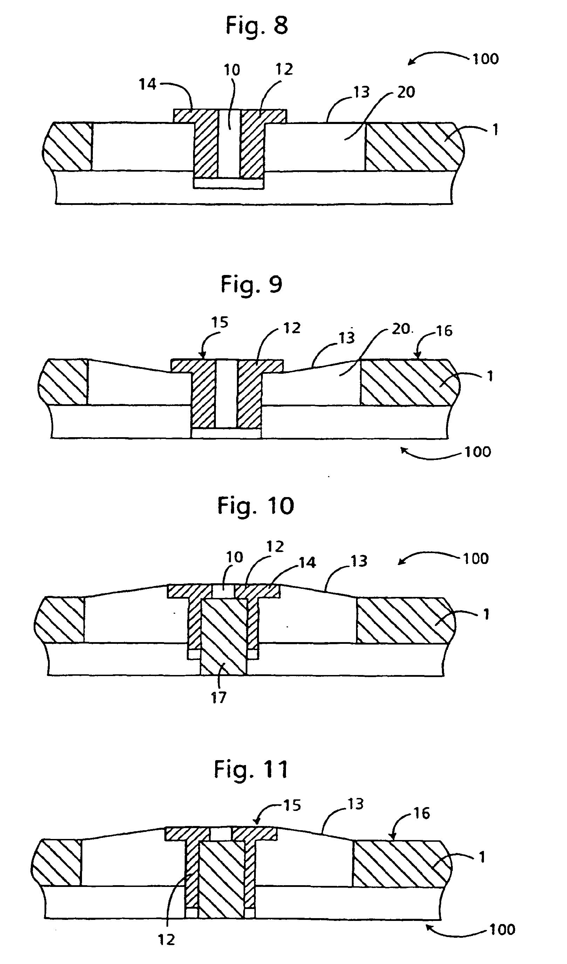

Dabei besteht die Möglichkeit, den Vakuumkopf, der mit Unterdruck beaufschlagt wird, um einen Wafer zu halten, in Richtung senkrecht zur Ebene des Greifers 100 verstellbar und gegebenenfalls kippbar auszugestalten. Ausführungsformen, wie dies in der Praxis ausgeführt sein kann - auch die mit Unterdruck beaufschlagte Öffnung 10 kann beweglich sein - sind in den Fig. 8 bis 11 gezeigt.

Bei der in Fig. 8 und 9 gezeigten Ausführungsform ist ein Vakuumkopf 12, nämlich ein Vakuumpin, vorgesehen, der mittig eine mit Unterdruck beaufschlagte Öffnung 10 besitzt. Der Vakuumkopf 12 sitzt mit einem Randflansch 14 von oben her auf einer flexiblen Folie 13 auf, welche die Oberseite des Grundkörpers 1 des Greifers 100 abdeckt. Wird der Vakuumkopf 12 mit Unterdruck beaufschlagt, so bewegt er sich in die in Fig. 9 gezeigte Stellung, in der seine nach außen weisende Endfläche 15 in der Ebene 16 liegt, die von der einem Wafer zugekehrten Fläche 25 des Greifers 100 definiert ist.

Bei der in Fig. 10 und 11 gezeigten Ausführungsform ist der Vakuumkopf 12 mit seinem Randflansch 14 von unten her an der flexiblen Folie 13 anliegend befestigt. Zusätzlich ist bei der in den Fig. 10 und 11 gezeigten Ausführungsform eine Druckfeder 17 vorgesehen, die den Vakuumkopf 12 in die in Fig. 10 gezeigte über den Greifer 100 vorstehende Lage drückt. Auch bei der in den Fig. 10 und 11 gezeigten Ausführungsform bewegt sich der Vakuumkopf 12 senkrecht zur Ebene des Greifers 100, wenn er mit Unterdruck beaufschlagt wird und nimmt schließlich die in Fig. 11 gezeigte Lage ein, in der seine Endfläche 15 mit der Fläche 16 des Greifers 100 fluchtet.

Wenn der erfindungsgemäße Greifer 100 zusätzlich mit durch Unterdruck beaufschlagbaren Öffnungen, wie beispielsweise Vakuumköpfen 12 der Fig. 8 bis 11 ausgerüstet ist, kann die Zufuhr von Druckgas und/oder das Beaufschlagen mit Unterdruck - es wirkt dann nur noch die Elektrostatik - beendet werden, sobald der Wafer an den Greifer 100 angelegt ist. Es bleiben dann die Vakuumköpfe 12 in der versenkten, beispielsweise in den Fig. 9 und 11 gezeigten Lage, wenn eine Ausführungsform eines Greifers 100 vorliegt, die wie in Fig. 1 gezeigt eine durchgehende ebene Fläche auf der dem Wafer zugekehrten Seite 25 des Greifers 100 besitzt. Bei einer stufenförmigen Ausführungsform (Fig. 2 und 3) eines Greifers werden die Vakuumköpfe 12, wenn sie mit Unterdruck beaufschlagt werden, nur so weit in den Greifer 100 versenkt, dass ihre obere Endfläche 15 in der von der oberen Endfläche des Vorsprunges 8 definierten Ebene liegen.

Bei der Ausführungsform mit Vakuumköpfen 12 können mehrere solche Vakuumköpfe 12 vorgesehen sein, deren Anordnung auf dem Greifer 100 weitgehend beliebig ist. Die Vakuumköpfe 12 sind beispielsweise an einer flexiblen Folie 13 befestigt und im Grundkörper 1 des Greifers 100 befindet sich unterhalb jedes Vakuumkopfes 12 eine Vakuumkammer 20. Wenn die Vakuumköpfe 12 nicht mit Unterdruck beaufschlagt werden, ragen die oberen Endflächen 15 der Vakuumköpfe 12 aus Greiferoberfläche 25 hervor, wobei ein Überstand von einigen Zehntelmillimeter möglich ist.

Bei der in den Fig. 8 und 9 gezeigten Ausführungsformen ist der Vakuumkopf 12 in eine Öffnung der flexiblen Folie 13 eingesetzt. Bei der in Fig. 10 und 11 gezeigten Ausführungsform liegt der Vakuumkopf 12 mit seiner oberen Endfläche von unten her an der flexiblen Folie 13 an, wobei im Bereich der mit Unterdruck beaufschlagten Öffnung 10 des Vakuumkopfes 12 in der flexiblen Folie 13 eine Öffnung vorgesehen ist.

Das Beaufschlagen der Vakuumköpfe 12 mit Unterdruck wird beispielsweise durch ein System von Kanälen im Grundkörper 1 des Greifers 100 verwirklicht.

Die in den Zeichnungen gezeigten Ausführungsbeispiele sind lediglich bevorzugte Ausführungsformen der Erfindung. Wesentlich ist, dass sowohl Einrichtungen, z.B. Austrittsöffnungen oder Düsen für Druckgas zum Erzeugen von Kräften nach dem Bernoulliprinzip und gleichzeitig Einrichtungen, z.B. bipolar und entgegengesetzt angesteuerte Elektroden, vorgesehen sind, um einen Wafer am Greifer durch Coulombsche Anziehungskräfte, die durch elektrostatische Felder erzeugt werden, zuhalten.

Die segmentförmigen Elektroden der Fig. 6 und 7 sind bevorzugt zusammengeschaltet, d.h. mit gleichgerichtetem Potential aufgeladen, wobei dieses Potential aber dem Potential, mit dem die mittig angeordnete kreisförmige Elektrode 3 aufgeladen ist, entgegengesetzt ist.

### Bezugszeichenliste

- 1: Grundkörper
- 2: Elektrode/zweite Einrichtung
- 3: Elektrode/zweite Einrichtung
- 4: Dielektrikum
- 5: Düse/erste Einrichtung
- 6: Kanal
- 7: Stufe
- 8: kreisförmige Erhebung
- 10: Öffnung
- 12: Vakuumkopf
- 13: flexible Folie
- 14: Randflansch
- 15: obere Endfläche
- 16: Ebene
- 17: Druckfeder
- 20: Vakuumkammer
- 25: Oberseite
- 26: Unterseite
- 100: erfindungsgemäße Halteeinrichtung/Greifeinrichtung/Greifer

## Patentansprüche

1. Halteeinrichtung zum Halten scheibenförmiger Dünnwafer,
- wobei mindestens eine erste Einrichtung (5) zum Erzeugen von einen Dünnwafer zur Halteeinrichtung (100) hin ziehenden Kräften aufgrund des Bernoulliprinzips durch ein strömendes Gas vorgesehen ist, durch welche der Dünnwafer planarisierbar ist, **dadurch gekennzeichnet, daß**
- mindestens eine zweite Einrichtung (2, 3) zum Halten des bereits plariarisierten Dünnwafers an der . Halteeinrichtung (100) aufgrund durch wenigstens ein elektromagnetisches Feld erzeugter Kräfte vorgesehen ist und
- die erste Einrichtung (5) und die zweite Einrichtung in der Halteeinrichtung einteilig, miteinander integriert und aneinander fixiert ausgebildet sind.

2. Halteeinrichtung nach Anspruch 1,
**dadurch gekennzeichnet,**
**dass** die zweite Einrichtung (2, 3) zur Erzeugung mindestens eines elektrostatischen Feldes und/oder zur Erzeugung Coulombscher Kräfte ausgebildet ist.

3. Halteeinrichtung nach einem der vorangehenden Ansprüche,
**dadurch gekennzeichnet,**
**dass** die erste Einrichtung (5) eine in der dem scheibenförmigen Gegenstand zugekehrten Fläche (25) ausmündende Düse (5) ist oder aufweist, die im Betrieb mit Druckgas beaufschlagbar ist.

4. Halteeinrichtung nach Anspruch 3,
**dadurch gekennzeichnet,**
**dass** die Düse (5) unter spitzem Winkel zur dem scheibenförmigen Gegenstand zugekehrten Fläche (25) der Halteeinrichtung (100) in dieser Fläche (25) ausmündet.

5. Halteeinrichtung nach Anspruch 3,
**dadurch gekennzeichnet,**
**dass** die Düse (5) im Wesentlichen parallel zur dem scheibenförmigen Gegenstand zugekehrten Fläche (25) der Halteeinrichtung (100) ausmündet.

6. Halteeinrichtung nach Anspruch 5,
**dadurch gekennzeichnet,**
**dass** die Düse (5) im Bereich einer Stufe (7) in der dem scheibenförmigen Gegenstand zugekehrten Fläche (25) der Halteeinrichtung (100) ausmündet.

7. Halteeinrichtung nach einem der Ansprüche 3 bis 6,
**dadurch gekennzeichnet,**
**dass** die Düse (5) kreisringförmig oder kreisbogenförmig ausgebildet ist und/oder
**dass** mehrere Düsenbohrungen vorgesehen sind, die im Bereich eines zum Zentrum der Halteeinrichtung (100) konzentrischen Kreises ausmünden.

8. Halteeinrichtung nach einem der vorangehenden Ansprüche,
**dadurch gekennzeichnet,**
**dass** die zweite Einrichtung (2, 3) jeweils im Wesentlichen als Elektrode (2, 3) ausgebildet ist oder eine solche aufweist.

9. Halteeinrichtung nach einem der vorangehenden Ansprüche,
**dadurch gekennzeichnet,**
**dass** in der Halteeinrichtung (100) die zweite Einrichtung (2, 3), insbesondere die Elektroden (2, 3), in der dem scheibenförmigen Gegenstand zugekehrten Fläche vorgesehen sind, wobei deren dem scheibenförmigen Gegenstand zugekehrte Fläche (25) durch ein Dielektrikum (4) abgedeckt sind, und
**dass** die Elektroden (2, 3) zur Ausbildung des elektromagnetischen oder elektrostatischen Feldes im Betrieb bipolar ansteuerbar ausgebildet sind.

10. Halteeinrichtung nach Anspruch 9,
**dadurch gekennzeichnet,**
**dass** das Flächenverhältnis zwischen der wenigstens einen positiv und der wenigstens einen negativ geladenen Elektrode (2, 3) in der Größenordnung von eins liegt.

11. Halteeinrichtung nach Anspruch 9 oder 10,
**dadurch gekennzeichnet,**
**dass** in der Mitte der Halteeinrichtung (100) eine kreisförmige Elektrode (3) und außerhalb derselben eine kreisförmige Elektrode (2) vorgesehen sind.

12. Halteeinrichtung nach Anspruch 11,
**dadurch gekennzeichnet,**
**dass** die Düse (5) zwischen den Elektroden (2, 3) angeordnet ist.

13. Halteeinrichtung nach Anspruch 9 oder 10,
**dadurch gekennzeichnet,**
**dass** zwei halbkreisförmige Elektroden (2, 3) vorgesehen sind.

14. Halteeinrichtung nach Anspruch 13,
**dadurch gekennzeichnet,**
**dass** die Düse (5) außerhalb der Elektroden (2, 3) angeordnet ist.

15. Halteeinrichtung nach Anspruch 9 oder 10,
**dadurch gekennzeichnet,**
**dass** eine kreisförmige Elektrode (3) und wenigstens zwei weitere Elektroden (2) radial außerhalb derselben angeordnet sind.

16. Halteeinrichtung nach Anspruch 15,
**dadurch gekennzeichnet,**
**dass** die außerhalb der mittig angeordneten kreisförmigen Elektrode (3) angeordneten Elektroden (2) kreisringsegmentförmig ausgebildet sind.

17. Halteeinrichtung nach Anspruch 15 oder 16,
**dadurch gekennzeichnet,**
**dass** die Düse (5) rings um die mittige Elektrode (3) und radial innerhalb der außerhalb angeordneten Elektroden (2) angeordnet ist.

18. Halteeinrichtung nach einem der Ansprüche 9 bis 17,
**dadurch gekennzeichnet,**
**dass** die Elektroden (2, 3) voneinander wenigstens durch ein Dielektrikum (4) isoliert sind.

19. Halteeinrichtung nach einem der vorangehenden Ansprüche,
**dadurch gekennzeichnet,**
**dass** in der dem scheibenförmigen Gegenstand zugekehrten Fläche (25) der Halteeinrichtung (100) wenigstens eine mit Unterdruck beaufschlagbare Öffnung (10) vorgesehen ist.

20. Halteeinrichtung nach Anspruch 19,
**dadurch gekennzeichnet,**
**dass** die mit Unterdruck beaufschlagbare Öffnung (10) in einem Vakuumkopf (12) vorgesehen ist und
**dass** der Vakuumkopf (12) senkrecht zur Ebene der Halteeinrichtung (100) beweglich und gegebenenfalls kippbar/schrägstellbar ist.

21. Halteeinrichtung nach Anspruch 20,
**dadurch gekennzeichnet,**
**dass** ohne Beaufschlagen des Vakuumkopfes (12) mit Unterdruck die äußere Endfläche (15) des Vakuumkopfes (12) über die dem scheibenförmigen Gegenstand zugekehrte Fläche (25) der Halteeinrichtung (100) vorsteht.

22. Halteeinrichtung nach Anspruch 10 oder 21,
**dadurch gekennzeichnet,**
**dass** der Vakuumkopf (12) von einer flexiblen Folie (13) gehalten ist.

23. Halteeinrichtung nach Anspruch 22,
**dadurch gekennzeichnet,**
**dass** der Vakuumkopf mit einem Randflansch (14) von außen auf der flexiblen Folie (13) aufsitzt.

24. Halteeinrichtung nach Anspruch 22,
**dadurch gekennzeichnet,**
**dass** der Vakuumkopf (12) von innen her an der flexiblen Folie (13) anliegt.

25. Halteeinrichtung nach einem der Ansprüche 22 bis 24,
**dadurch gekennzeichnet,**
**dass** der Vakuumkopf (12) an der Folie (13) befestigt ist.

26. Halteeinrichtung nach einem der Ansprüche 20 bis 25,
**dadurch gekennzeichnet,**
**dass** im Bereich des Vakuumkopfes (12) im Grundkörper (1) der Halteeinrichtung (100) eine Kammer (20) ausgespart ist, die mit Unterdruck beaufschlagbar ist.

27. Halteeinrichtung nach einem der Ansprüche 20 bis 26,
**dadurch gekennzeichnet,**
**dass** dem Vakuumkopf (12) eine Druckfeder (17) zugeordnet ist, die ihn in seine mit seiner Endfläche (15) über die Fläche (16) der Halteeinrichtung (100) überstehende Lage belastet.

## Claims

1. Holding device for holding thin wafers in the form of discs,
- with at least one first device (5) being provided for the production of forces which draw a thin wafer towards the holding device (100) on the basis of the Bernoulli principle by means of a flowing gas, by means of which the thin wafer can be planarized, **characterized in that**
- at least one second device (2, 3) is provided for holding the already planarized thin wafer on the holding device (100) on the basis of forces which are produced by at least one electromagnetic field, and
- the first device (5) and the second device are formed integrally in the holding device, are integrated with one another, and are fixed to one another.

2. Holding device according to Claim 1,
**characterized in that**
the second device (2, 3) is designed to produce at least one electrostatic field and/or to produce Coulomb forces.

3. Holding device according to one of the preceding claims,
**characterized in that**
the first device (5) is or has a nozzle (5) which opens in the surface (25) facing the object in the form of a disc to which compressed gas can be applied during operation.

4. Holding device according to Claim 3,
**characterized in that**
the nozzle (5) opens at an acute angle to that surface (25) of the holding device (100) facing the object in the form of a disc, and in this surface (25).

5. Holding device according to Claim 3,
**characterized in that**
the nozzle (5) opens essentially parallel to that surface (25) of the holding device (100) which faces the object in the form of a disc.

6. Holding device according to Claim 5,
**characterized in that**
the nozzle (5) opens in the area of a step (7) **in that** surface (25) of the holding device (100) which faces the object in the form of a disc.

7. Holding device according to one of Claims 3 to 6,
**characterized in that**
the nozzle (5) is in the form of a circular ring or circular arc, and/or
**in that** a number of nozzle holes are provided, and open in the area of a circle which is concentric with respect to the centre of the holding device (100).

8. Holding device according to one of the preceding claims,
**characterized in that**
the second device (2, 3) is in each case essentially in the form of an electrode (2, 3) or has such an electrode.

9. Holding device according to one of the preceding claims,
**characterized in that**
the second device (2, 3), in particular the electrodes (2, 3), is provided in the holding device (100), in the surface facing the object in the form of a disc, with its surface (25) facing the object in the form of a disc being covered by a dielectric (4), and
**in that** the electrodes (2, 3) are designed such that they can be driven in bipolar form during operation in order to form the electromagnetic or electrostatic field.

10. Holding device according to Claim 9,
**characterized in that**
the ratio of the areas of the at least one positively charged electrode (2) and the at least one negatively charged electrode (3) is in the order of magnitude of unity.

11. Holding device according to Claim 9 or 10,
**characterized in that**
a circular electrode (3) is provided in the centre of the holding device (100), and a circular electrode (2) is provided outside this circular electrode (3).

12. Holding device according to Claim 11,
**characterized in that**
the nozzle (5) is arranged between the electrodes (2, 3).

13. Holding device according to Claim 9 or 10,
**characterized in that**
two semicircular electrodes (2, 3) are provided.

14. Holding device according to Claim 13,
**characterized in that**
the nozzle (5) is arranged outside the electrodes (2, 3).

15. Holding device according to Claim 9 or 10,
**characterized in that**
a circular electrode (3) and at least two further electrodes (2) are arranged radially outside this.

16. Holding device according to Claim 15,
**characterized in that**
the electrodes (2) which are arranged outside the centrally arranged circular electrode (3) are in the form of circular ring segments.

17. Holding device according to Claim 15 or 16,
**characterized in that**
the nozzle (5) is arranged around the central electrode (3) and radially within the electrodes (2) which are arranged on the outside.

18. Holding device according to one of Claims 9 to 17,
**characterized in that**
the electrodes (2, 3) are isolated from one another at least by a dielectric (4).

19. Holding device according to one of the preceding claims,
**characterized in that**
at least one opening (10), to which a reduced pressure can be applied, is provided **in that** surface (25) of the holding device (100) facing the object in the form of a disc.

20. Holding device according to Claim 19,
**characterized in that**
the opening (10) to which a reduced pressure can be applied is provided in a vacuum head (12), and that the vacuum head (12) can move at right angles to the plane of the holding device (100) and, possibly, can be tilted/inclined.

21. Holding device according to Claim 20,
**characterized in that**
the outer end surface (15) of the vacuum head (12) projects beyond that surface (25) of the holding device (100) which faces the object in the form of a disc when no reduced pressure is applied to the vacuum head (12).

22. Holding device according to Claim 10 or 21,
**characterized in that**
the vacuum head (12) is held by a flexible sheet (13).

23. Holding device according to Claim 22,
**characterized in that**
the vacuum head is seated with an edge flange (14) from the outside on the flexible sheet (13).

24. Holding device according to Claim 22,
**characterized in that**
the vacuum head (12) rests on the flexible sheet (13) from the inside.

25. Holding device according to one of Claims 22 to 24,
**characterized in that**
the vacuum head (12) is attached to the sheet (13).

26. Holding device according to one of Claims 20 to 25,
**characterized in that**
a chamber (20) to which a reduced pressure can be applied is cut out in the area of the vacuum head (12) in the base body (1) of the holding device (100).

27. Holding device according to one of Claims 20 to 26,
**characterized in that**
the vacuum head (12) has an associated compression spring (17), which loads it to its position in which its end surface (15) projects beyond the surface (16) of the holding device (100).

## Revendications

1. Dispositif de maintien de tranches minces en forme de disques,
- dans lequel il est prévu au moins un premier dispositif (5) de production, sur la base du principe de Bernoulli par un courant gazeux, de forces attirant une tranche mince vers le dispositif (100) de maintien, par lequel la tranche mince peut être rendue plane, **caractérisé en ce que**
- il est prévu au moins un deuxième dispositif (2, 3) de maintien de la tranche mince, déjà rendue plane sur le dispositif (100) de maintien, en raison de forces produites par au moins un champ électromagnétique et
- le premier dispositif (5) et le deuxième dispositif sont intégrés ensemble en une pièce dans le dispositif de maintien et sont immobilisés l'un contre l'autre.

2. Dispositif de maintien suivant la revendication 1,
**caractérisé en ce que** le deuxième dispositif (2, 3) est constitué pour la production d'au moins un champ électrostatique et/ou pour la production de forces de Coulomb.

3. Dispositif de maintien suivant l'une des revendications précédentes,
**caractérisé en ce que** le premier dispositif (5) est ou comporte une buse (5) débouchant dans la surface (25) tournée vers l'objet en forme de disque et pouvant être alimentée en fonctionnement en gaz comprimé.

4. Dispositif de maintien suivant la revendication 3,
**caractérisé en ce que** la buse (5) débouche dans la surface (25), tournée vers l'objet en forme de disque, du dispositif (100) de maintien en faisant en angle aigu avec cette surface (25).

5. Dispositif de maintien suivant la revendication 3,
**caractérisé en ce que** la buse (5) débouche sensiblement parallèlement à la surface (25), tournée vers l'objet en forme de disque, du dispositif (100) de maintien.

6. Dispositif de maintien suivant la revendication 5,
**caractérisé en ce que** la buse (5) débouche dans la zone d'un palier (7) de la surface (25), tournée vers l'objet en forme de disque, du dispositif (100) de maintien.

7. Dispositif de maintien suivant l'une des revendications 3 à 6,
**caractérisé en ce que** la buse (5) est de forme annulaire ou en forme d'arc de cercle et/ou
**en ce qu'**il est prévu plusieurs trous de buses, qui débouchent dans la zone d'un cercle concentrique au centre du dispositif (100) de maintien.

8. Dispositif de maintien suivant l'une des revendications précédentes,
**caractérisé en ce que** le deuxième dispositif (2, 3) est constitué respectivement sensiblement en électrode (2, 3) ou en comporte une.

9. Dispositif de maintien suivant l'une des revendications précédentes,
**caractérisé en ce qu'**il est prévu dans le dispositif (100) de maintien le deuxième dispositif (2, 3), notamment les électrodes (2, 3), dans la surface tournée vers l'objet en forme de disque, leur surface (25) tournée vers l'objet en forme de disque étant recouverte d'un diélectrique (4) et
**en ce que** les électrodes (2, 3) sont constituées pour la formation du champ électromagnétique ou électrostatique en fonctionnement, de façon à pouvoir être commandées de manière bipolaire.

10. Dispositif de maintien suivant la revendication 9,
**caractérisé en ce que** le rapport de surface entre la au moins une électrode (2) chargée positivement et la au moins une électrode (3) chargée négativement est de l'ordre de grandeur de un.

11. Dispositif de maintien suivant la revendication 9 ou 10,
**caractérisé en ce qu'**au milieu du dispositif (100) de maintien, sont prévues une électrode (3) circulaire et, à l'extérieur de celle-ci, une électrode (2) circulaire.

12. Dispositif de maintien suivant la revendication 11,
**caractérisé en ce que** la buse (5) est disposée entre les électrodes (2, 3).

13. Dispositif de maintien suivant la revendication 9 ou 10,
**caractérisé en ce qu'**il est prévu deux électrodes (2, 3) hémicirculaires.

14. Dispositif de maintien suivant la revendication 13,
**caractérisé en ce que** la buse (5) est disposée à l'extérieur des électrodes (2, 3).

15. Dispositif de maintien suivant la revendication 9 ou 10,
**caractérisé en ce qu'**il est prévu une électrode (3) circulaire, et au moins deux autres électrodes (2) sont disposées radialement à l'extérieur de celle-ci.

16. Dispositif de maintien suivant la revendication 15,
**caractérisé en ce que** les électrodes (2), disposées à l'extérieur de l'électrode (3) circulaire disposée au milieu, sont constituées en segments d'anneau de cercle.

17. Dispositif de maintien suivant la revendication 15 ou 16,
**caractérisé en ce que** la buse (5) est disposée tout autour de l'électrode (3) centrale et radialement à l'intérieur des électrodes (2) disposées à l'extérieur.

18. Dispositif de maintien suivant l'une des revendications 9 à 17,
**caractérisé en ce que** les électrodes (2, 3) sont isolées les unes des autres au moins par un diélectrique (4).

19. Dispositif de maintien suivant l'une des revendications précédentes,
**caractérisé en ce qu'**il est prévu dans la surface (25), tournée vers l'objet en forme de disque, du dispositif (100) de maintien au moins une ouverture (10) pouvant être mise en dépression.

20. Dispositif de maintien suivant la revendication 19,
**caractérisé en ce que** l'ouverture (10) pouvant être mise en dépression est prévue dans une tête (12) à vide et
**en ce que** la tête (12) à vide est mobile perpendiculairement au plan du dispositif (100) de maintien et, le cas échéant, peut être basculée/inclinée.

21. Dispositif de maintien suivant la revendication 20,
**caractérisé en ce que**, sans alimentation de la tête (12) à vide par une dépression, la surface (15) extérieure d'extrémité de la tête (12) à vide est en saillie de la surface, tournée vers l'objet en forme de disque, du dispositif (100) de maintien.

22. Dispositif de maintien suivant la revendication 10 ou 21,
**caractérisé en ce que** la tête (12) à vide est maintenue par un ruban (13) souple.

23. Dispositif de maintien suivant la revendication 22,
**caractérisé en ce que** la tête à vide repose par un rebord (14) de bord de l'extérieur sur le ruban (13) souple.

24. Dispositif de maintien suivant la revendication 22,
**caractérisé en ce que** la tête (12) à vide s'applique de l'intérieur au ruban (13) souple.

25. Dispositif de maintien suivant l'une des revendications 22 à 24,
**caractérisé en ce que** la tête (12) à vide est fixée au ruban (13).

26. Dispositif de maintien suivant l'une des revendications 20 à 25,
**caractérisé en ce que** dans la zone de la tête (12) à vide, il est ménagé, dans l'embase (1) du dispositif (100) de maintien, une chambre (20) qui peut être mise en dépression.

27. Dispositif de maintien suivant l'une des revendications 20 à 26,
**caractérisé en ce qu'**il est associé à la tête (12) à vide un ressort (17) de compression, qui met la tête, par sa surface (15) d'extrémité, en saillie de la surface (16) du dispositif (100) de maintien.
